# DEMANDE DE BREVET EUROPEEN

(11) **EP 1 168 364 A1**
(43) Date de publication de la demande: **02.01.2002**
(21) Numéro de dépôt: 01401726.3
(22) Date de dépôt: 28.06.2001
(51) Int. Cl.: G11C 16/12, G11C 5/14

(54) **Dispositif de contrôle d'alimentation dans un circuit intégré comprenant des éléments de mémoire non volatile électriquement programmable**

(30) Priorité: 30.06.2000 FR 0008548
(71) Demandeur: STMicroelectronics S.A., 92120 Montrouge (FR)
(72) Inventeur: Fournel, Richard, 94230 Cachan (FR)
(74) Mandataire: Ballot, Paul

(57) **Abrégé**

Dans un circuit intégré (1) à mémoire non volatile électriquement programmable (MEM) avec circuiterie (3) de sélection et programmation associée, on prévoit un dispositif de contrôle (5) de la tension appliquée sur un noeud (N) d'entrée d'alimentation cette circuiterie (3) de sélection et programmation, pour appliquer soit une haute tension (HV), soit une tension d'alimentation logique (Vdd), en fonction d'un signal (IN) de commande de programmation.

## Description

La présente invention concerne un dispositif de contrôle d'alimentation dans un circuit intégré comprenant des éléments de mémoire non volatile électriquement programmable.

Dans les nouvelles technologies submicroniques, les épaisseurs d'oxydes sont très faibles, par exemple de trente-cinq, cinquante-cinq ou soixante-dix angströms. Un oxyde de trente-cinq angströms ne peut supporter une tension de plus de deux volts. Un oxyde de cinquante-cinq ou soixante-dix angströms ne peuvent supporter une tension de plus de quatre volts.

Ainsi, avec les nouvelles technologies submicroniques, les circuits intégrés reçoivent une tension d'alimentation logique de niveau plus faible, optimisé pour permettre le meilleur temps de réponse (vitesse) tout en assurant la fiabilité du circuit (protection des oxydes).

Dans certains circuits intégrés, on peut avoir des parties du circuit qui utilisent des épaisseurs d'oxydes différentes. Pour assurer les meilleures performances, on prévoit que chaque partie reçoit la tension d'alimentation optimale correspondante. On peut par exemple avoir un circuit intégré dont une partie est alimentée en 3,3 volts et l'autre partie en 1,8 volts, en fonction de l'épaisseur des oxydes dans chaque partie. Habituellement, le circuit intégré reçoit alors comme alimentation logique externe, celle de niveau le plus haut, 3,3 volts dans l'exemple. Un diviseur de tension est prévu dans le circuit pour fournir le niveau plus bas d'alimentation logique, 1,8 volts dans l'exemple. Ce diviseur est tel qu'il est apte à supporter le niveau de tension le plus élevé.

Dans l'invention, on s'intéresse aux circuits intégrés en technologies submicroniques qui comprennent une mémoire non volatile électriquement programmable, par exemple, une mémoire EEPROM, EPROM, flash EPROM, ....

De telles mémoires utilisent pour leur programmation, des tensions de niveaux supérieurs aux tensions d'alimentation logique du circuit intégré. Ces niveaux de tensions de programmation dépendent essentiellement de la technologie considérée.

Un élément de mémoire non volatile électriquement programmable comprend de façon habituelle au moins un transistor à grille flottante. La programmation d'un "0" ou d'un "1" dans cet élément est obtenue par application de tensions de programmation appropriées, sur la grille, le drain , la source et la prise de caisson (substrat) de ce transistor. Dans un exemple typique d'un circuit intégré en technologie submicronique, les niveaux de tension de programmation utilisés sont 5 volts (drain), 9 volts (grille) et la masse (source).

Pour programmer ces éléments mémoire, il faut donc disposer d'au moins une haute tension, supérieure aux tensions d'alimentation logique du circuit intégré. Les niveaux de tension de programmation nécessaires sont produits en interne, à partir de cette haute tension, par une circuiterie de sélection et programmation des éléments mémoire, par exemple au moyen d'un circuit de type additionneur ou multiplieur de tension.

Dans l'invention, on s'intéresse aux circuits intégrés qui reçoivent en permanence cette haute tension sur une broche externe.

Certains des éléments de la circuiterie de sélection et programmation, et plus particulièrement leurs oxydes, peuvent voir en permanence cette haute tension. Selon les autres niveaux de tension qui leur sont appliqués, ils peuvent donc avoir à leur bornes, un trop fort potentiel, et ce, de façon fréquente ou quasi-permanente. Or on a vu que dans les technologies submicroniques, les oxydes sont particulièrement minces. Même en utilisant la plus grande épaisseur disponible dans la technologie considérée, il faudrait prévoir pour chaque oxyde à protéger un élément de protection de type cascode pour que la fiabilité ne soit pas dégradée.

Pour des raisons de complexité, de fonctionnalité, et de coût, une telle solution n'est pas satisfaisante.

Un objet de l'invention est d'améliorer la fiabilité des tels circuits intégrés en technologie submicroniques à mémoire non volatile électriquement programmable, par un dispositif de protection globale, prévu au niveau de la broche haute tension.

L'idée à la base de l'invention, est un dispositif de contrôle d'alimentation, tel que les éléments du circuit de sélection et programmation associés aux éléments de mémoire non volatile sont alimentés par la tension d'alimentation logique au moins en dehors des cycles de programmation. Avec un dispositif de contrôle d'alimentation selon l'invention, les circuits de sélection et programmation associés aux éléments de mémoire non volatile sont soumis aux niveaux des tensions de programmation pendant les seuls cycles de programmation proprement dits. Le reste du temps, ils reçoivent la tension d'alimentation logique, de niveau plus bas, sans danger pour les oxydes submicroniques. Ainsi, le temps d'exposition aux niveaux de tension de programmation est-il réduit de façon significative. La fiabilité des circuits intégrés comprenant un tel dispositif de contrôle d'alimentation est très améliorée.

Un dispositif de contrôle d'alimentation selon l'invention comprend deux commutateurs de tension, pour commuter l'un la haute tension, l'autre une tension d'alimentation logique, sur un noeud d'entrée d'alimentation de la circuiterie de sélection et programmation associée aux éléments mémoire. Ces commutateurs sont commandés de façon complémentaire par un translateur de niveaux de tension, connecté entre la haute tension et la masse. Ce translateur est commandé par un signal binaire de commande généré en interne par le circuit intégré. Le niveau actif de ce signal de commande, pour commuter la haute tension, peut correspondre à un cycle d'écriture d'éléments de la mémoire non volatile. En dehors du cycle d'écriture, ce signal de commande est à son niveau inactif, par lequel c'est la tension d'alimentation qui est commutée sur le noeud d'entrée d'alimentation de la circuiterie de sélection et programmation.

Un cycle d'écriture d'éléments de mémoire comprend typiquement, pour chaque adresse de programmation, une opération de programmation suivie d'une vérification en lecture. Le signal d'écriture ne reste actif que le temps du cycle d'écriture, des signaux de contrôle de (lecture, changement d'adresse) permettant de réduire la durée d'exposition aux hautes tensions.

Dans un perfectionnement, le translateur de niveaux est dimensionné pour être capable de commuter très rapidement, de sorte qu'il est possible de commuter la haute tension à chaque changement d'adresse de programmation, pour effectuer l'opération de programmation à cette adresse puis de commuter la tension d'alimentation le temps de la vérification en lecture de cette programmation. De cette façon le temps d'exposition à la haute tension est réduit au maximum.

Telle que caractérisée, l'invention concerne donc un circuit intégré comprenant des éléments de mémoire non volatile électriquement programmable et une circuiterie de sélection et programmation associée, le circuit intégré comprenant comme tensions d'alimentation, une tension de référence de masse, au moins une tension d'alimentation logique, et une haute tension, ladite haute tension étant utilisée pour fournir les niveaux de tension nécessaires à la programmation d'un ou d'éléments de mémoire non volatile. Selon l'invention, ce circuit intégré comprend en outre un dispositif de contrôle de la tension appliquée sur un noeud d'entrée d'alimentation de la circuiterie de sélection et programmation, pour appliquer soit la haute tension, soit une tension d'alimentation logique, en fonction d'un signal de commande de programmation.

D'autres caractéristiques et avantages de l'invention sont détaillés dans la description suivante, faite à titre indicatif et non limitatif de l'invention et en référence aux dessins annexés dans lesquels :
- la figure 1 représente un circuit intégré en technologie submicronique comprenant des éléments de mémoire non volatile et un dispositif de contrôle d'alimentation selon l'invention ;
- la figure 2 est un schéma détaillé d'un mode de réalisation d'un dispositif de contrôle d'alimentation selon l'invention ;
- la figure 3 représente une variante d'utilisation d'un dispositif de contrôle selon l'invention, dans un circuit intégré à deux tensions d'alimentation logique ; et
- la figure 4 représente un schéma de principe de la génération du signal de commande du dispositif de contrôle d'alimentation selon l'invention.

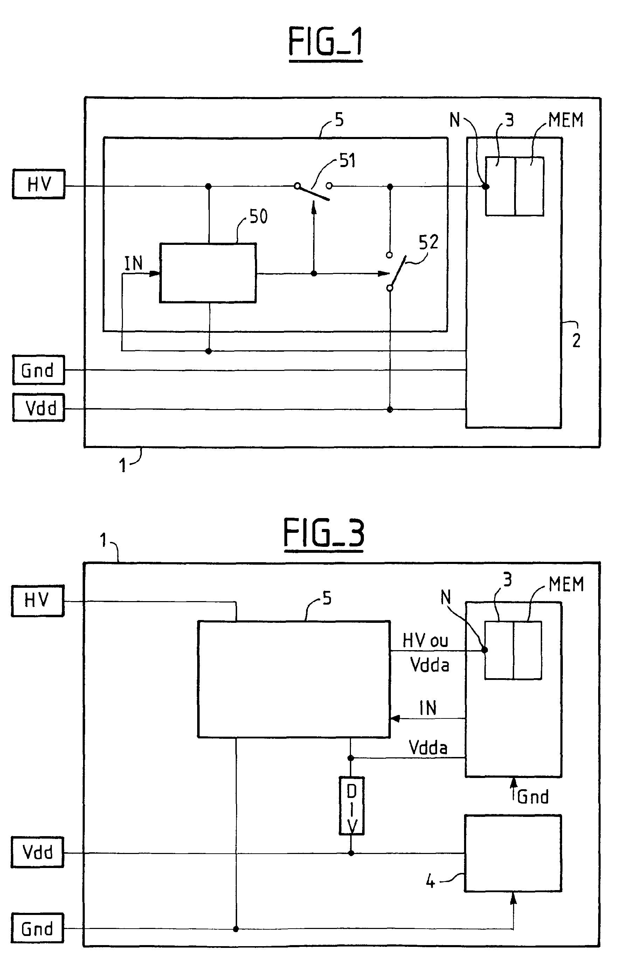

Sur la figure 1, on a représenté de façon schématique un circuit intégré 1 en technologie submicronique. Ce circuit intégré reçoit sur des broches externes, la masse Gnd, une tension d'alimentation logique Vdd et une haute tension HV. Ce circuit intégré comprend une circuiterie logique 2 non détaillée qui peut comprendre par exemple, un microprocesseur, de la mémoire ROM, RAM..., ainsi qu'une mémoire non volatile électriquement programmable MEM et une circuiterie 3 de sélection et programmation associée.

La circuiterie 3 de sélection et programmation reçoit en plus de la tension d'alimentation logique Vdd et de la masse Gnd, une tension appliquée par un dispositif 5 de contrôle selon l'invention, sur un noeud d'entrée N d'alimentation. Selon que l'on est en cycle d'écriture (ou de programmation) ou pas, ce noeud reçoit la haute tension HV ou la tension d'alimentation logique Vdd.

Ces différentes tensions permettent à cette circuiterie 3 de sélection et programmation de produire et d'appliquer de façon contrôlée les niveaux de tensions nécessaires sur les éléments de la mémoire en fonction de l'opération à réaliser : lecture, écriture d'un "0" ou d'un "1", lecture de vérification de la programmation.

Le dispositif 5 de contrôle selon l'invention est commandé par un signal de commande binaire IN généré en interne par la circuiterie 2.

Par le dispositif 5 de contrôle selon l'invention, le noeud N d'entrée de la circuiterie 3 de sélection et programmation n'est porté à la haute tension HV que pendant les cycles d'écriture ou de programmation. En dehors de ces cycles, le noeud N est porté à la tension d'alimentation logique Vdd.

Le dispositif 5 de contrôle selon l'invention comprend deux commutateurs 51 et 52. Un premier commutateur 51 est connecté entre la haute tension HV et le noeud N d'entrée d'alimentation de la circuiterie 3 de sélection et programmation. Un deuxième commutateur 52 est connecté entre la tension d'alimentation Vdd et le noeud N.

Les deux commutateurs 51 et 52 sont commandés par des moyens 50 de façon complémentaire, en sorte qu'un seul soit fermé à un moment donné, pour appliquer la tension associée sur le noeud d'entrée N.

Les moyens 50 sont en pratique un translateur de niveaux apte à fournir en sortie un signal binaire dont les deux niveaux haut et bas correspondent respectivement au moins au niveau de la haute tension HV à commuter et au maximum, au niveau de la tension d'alimentation logique Vdd à commuter.

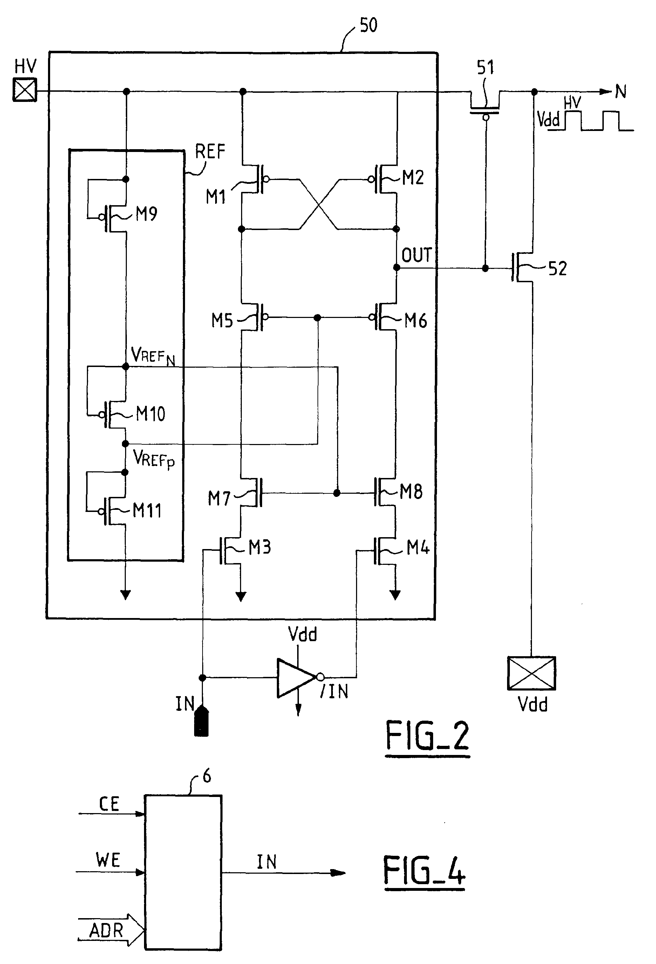

Un exemple de réalisation d'un dispositif de contrôle selon l'invention est détaillé sur la figure 2.

Le translateur 50 est commandé par le signal binaire de commande IN. Il est alimenté entre la haute tension HV et la masse Gnd.

Pour que ce translateur ne soit pas fragilisé par la haute tension, il doit comporter un étage de protection à au moins un étage cascode. Cet étage de protection permet de limiter à des niveaux de tension intermédiaires les noeuds internes du translateur, en sorte qu'aucun transistor du translateur ne voit une trop haute tension à ses bornes.

Ainsi, dans l'exemple représenté, le translateur 50 comprend deux étages cascodes et un circuit REF de génération des tensions de référence des étages cascodes.

Ainsi, le translateur comprend dans chacune de ses deux branches, quatre transistors connectés en série entre la haute tension HV et la masse : un transistor de charge connecté à la haute tension, un transistor de commutation connecté à la masse et commandé par le signal binaire de commande (ou son inverse) et deux transistors cascodes, un pour protéger le transistor de charge, un autre pour protéger le transistor de commutation.

Dans un exemple de réalisation en technologie CMOS correspondant à la représentation de la figure 2, les transistors de commutation sont de type N et ont leurs sources connectées à la masse. Les transistors de charge sont de type P. Ils ont chacun leur source connectée à la haute tension HV et leur grille connectée au drain du transistor de charge de l'autre branche.

Dans la première branche, on a ainsi, en série entre la haute tension et la masse : un transistor de charge M1 de type P, un transistor cascode M5 de type P, un transistor cascode M7, de type N et un transistor de commutation M3, de type N. Dans l'autre branche, on a, de manière similaire : un transistor de charge M2 de type P, un transistor cascode M6 de type P, un transistor cascode M8, de type N et un transistor de commutation M4, de type N.

Le dispositif 5 de contrôle comprend un circuit REF de génération des tensions de référence V_{REF_{N}} et V_{REFₚ}, pour commander les grilles transistors cascode de type N et P. Dans un exemple de réalisation de ce circuit représenté sur la figure 3, ce circuit REF comprend trois transistors Mos M9, M10, M11 en série entre la haute tension HV et la masse. Ces trois transistors fonctionnent en résistance puisqu'ils ont chacun leur grille reliée à leur drain. Dans l'exemple, ils sont de type P. Les tensions de référence V_{REFₙ} et V_{REFₚ} sont obtenues en prenant la tension de part et d'autre du transistor du milieu M10.

Avec ces tensions de référence, chaque transistor cascode limite les excursions de tension à ses bornes.

Ainsi la source de chaque transistor cascode de type P ne peut pas descendre en dessous de V_{REFₚ} + Vtₚ, où Vtₚ est la tension de seuil du transistor cascode de type P.

De même, la source de chaque transistor cascode de type N ne peut pas monter au-dessus de V_{REFₙ} - Vtₙ, où Vtₙ est la tension de seuil du transistor cascode de type N.

Dans les translateurs de tension, le niveau du signal obtenu en sortie du translateur est habituellement soit celui de la haute tension, soit de la masse. Ceci est obtenu en se plaçant au point milieu d'une des branches, c'est à dire dans l'exemple, en prenant la sortie entre les deux transistors cascodes d'une branche.

Dans l'invention, en prenant la sortie dans une branche, entre le transistor de charge connecté à la haute tension, et le transistor cascode suivant, soit entre les transistors M2 et M6 dans l'exemple, le niveau du signal obtenu en sortie OUT du translateur est soit celui de la haute tension HV, soit un niveau de l'ordre de la tension d'alimentation logique Vdd à commuter. On verra que c'est ce qui permet de commander les deux commutateurs 51 et 52 sans stresser leurs oxydes, et sans craindre de fuites.

Le dispositif de contrôle comprend en outre deux commutateurs 51 et 52, commandés de façon complémentaire par la sortie OUT du translateur 50.

Dans l'exemple, le commutateur 51 est un transistor MOS de type P connecté entre la haute tension HV et le noeud N d'entrée d'alimentation de la circuiterie 3 de sélection et programmation; et le commutateur 52 est un transistor de type N connecté entre la tension d'alimentation logique Vdd et le noeud N d'entrée d'alimentation de la circuiterie 3 de sélection et programmation.

Lorsque le signal binaire de commande IN est à son niveau actif, correspondant dans l'exemple à l'état bas "0", on veut que la sortie OUT s'établisse à son niveau haut, pour rendre passant le transistor de commutation 51, afin de commuter la haute tension HV sur le noeud N et pour bloquer le transistor de commutation 52. Lorsque le signal IN est à "0", c'est le transistor M4 qui est passant et qui tire son drain à la masse. La sortie OUT descend pour s'établir à son niveau bas, donné par V_{REF_{P_}}+ Vt. En effet, les transistors cascode font que le niveau de la sortie OUT ne peut pas descendre sous V_{REF_{P_}}+ Vt.

Pour que le transistor 52 soit bloqué efficacement, alors que son drain, connecté au noeud N, est à la haute tension HV et que sa source est connectée à la tension d'alimentation logique Vdd, il faut appliquer sur sa grille au plus le niveau de la tension de sa source, soit 3,3 volts au maximum. En pratique, la valeur du niveau bas de la sortie OUT du translateur est obtenue en dimensionnant de façon appropriée les transistors du circuit de référence des transistors cascodes. Dans l'exemple, il faut donc dimensionner le circuit de référence pour que V_{REF_{P}} + Vt soit de l'ordre de 3 volts. On notera que 'effet de substrat vu par le transistor 52 facilite son blocage.

Lorsque le signal binaire de commande IN est à son niveau inactif, correspondant dans l'exemple à l'état haut "1", on veut que la sortie OUT s'établisse à son niveau bas, et rendre passant le transistor de commutation 52, pour commuter la tension d'alimentation logique Vdd sur le noeud N et pour bloquer le transistor de commutation 51. Lorsque le signal IN est à "1", c'est le transistor M3 qui devient passant. La sortie OUT remonte pour s'établir à HV, à 5 volts. Le transistor 52 est donc complètement passant. Il suffit d'une tension légèrement supérieure à sa tension de source pour le rendre passant. Le transistor 51 lui est bloqué.

Dans les deux cas, IN à "1" et IN à "0", les niveaux de tension appliqués aux bornes (drain, source, grille) des transistors 51 et 52 sont tels que ces transistors ne sont jamais stressés, assurant la fiabilité du système.

Sur la figure 3, on a représenté une variante selon laquelle le circuit intégré utilise deux tensions d'alimentation logiques, Vdd et Vdda, qui prennent par exemple les valeurs de 3,3 volts et 1,8 volts, correspondant sur le plan de la technologie, à des oxydes moins épais dans la partie alimentée sous la tension d'alimentation logique la plus basse Vdda (1,8 volts dans l'exemple). La tension d'alimentation logique plus basse, peut-être obtenue directement sur une broche externe, ou par division de l'alimentation logique principale Vdd, ce qui correspond à ce qui est représenté sur la figure 3. Dans l'exemple, on a Vdd=3,3 volts et Vdda=1,8 volts.

Dans un circuit intégré de ce type, le signal de commande IN du dispositif de contrôle d'alimentation peut indifféremment être issu de l'une ou l'autre partie du circuit intégré. S'il est fourni par la partie alimentée sous la tension d'alimentation logique Vdda, 1,8 volts dans l'exemple, les deux niveaux de tension du signal IN sont alors 1,8 volts et 0 volt. S'il est fourni par la partie alimentée sous la tension d'alimentation logique Vdd, 3,3 volts dans l'exemple, les deux niveaux de tension du signal IN sont alors 3,3 volts et 0 volt.

La tension d'alimentation logique commutée sur le noeud N d'entrée de la circuiterie de sélection et programmation peut être la tension d'alimentation logique Vdd ou la deuxième tension d'alimentation logique Vdda, indépendamment de la logique associée au signal de commande IN. Le translateur du dispositif de contrôle est alors adapté pour fournir en sortie OUT les niveaux nécessaires pour faire commuter correctement les transistors 51 et 52. Plus précisément, le circuit de référence cascode du translateur est alors dimensionné pour fournir comme niveau bas du signal OUT un niveau au maximum égal à Vdda.

Sur la figure 4, on a représenté schématiquement un circuit 6 de génération du signal de commande IN du dispositif de contrôle d'alimentation selon l'invention.

Dans l'exemple, ce circuit 6 reçoit comme signaux de contrôle, des signaux de sélection CE et d'écriture WE et les signaux d'adresse ADR.

Dans sa réalisation la plus simple, lorsque le signal de programmation WE est activé, WE=0, le signal IN passe à "0" pour commander l'application de la haute tension sur le noeud N d'entrée de la circuiterie de sélection et programmation. Dès que et tant que ce signal n'est pas activé (WE=1), c'est la tension d'alimentation logique qui est appliquée, Vdd ou Vdda selon l'option retenue.

Grâce aux signaux de contrôle et d'adresse, il est possible de n'appliquer la haute tension que durant la phase active de programmation. Dans ce cas, les changements d'adresse dans les phases de programmation sont effectués en basse tension. Dans ce cas, le translateur 50 doit être dimensionné pour avoir un temps de commutation très rapide. Dans cette mise en oeuvre, le temps d'application de la haute tension HV sur le noeud d'entrée d'alimentation de la circuiterie de sélection et programmation est réduite au minimum nécessaire. De cette façon, le circuit intégré est protégé au maximum contre les effets de stress dus à la haute tension, à moindre coût pour le circuit intégré, puisqu'il n'y a que le dispositif de contrôle à voir en permanence la haute tension qui lui est appliquée. L'application s'applique tout particulièrement dans le cas où la haute tension est appliquée au circuit intégré sur une broche externe, mais aussi si elle est fournie en interne par un circuit de type pompe de charges par exemple.

L'invention ne se limite pas aux exemples particuliers de mise en oeuvre, ni aux exemples particuliers de réalisation décrits. Il existe notamment de nombreuses variantes pratiques de translateurs, utilisables dans l'invention. En particulier, on peut utiliser plus généralement un translateur à transistors Mos à un ou plusieurs étages cascodes. L'étage cascode ou les étages cascodes peuvent comprendre des transistors MOS P uniquement ou des transistors MOS N uniquement.

On notera enfin que l'invention s'applique aussi bien pour la programmation d'éléments mémoire, de type EPROM, EEPROM ou autres organisés selon une matrice que pour la programmation d'éléments mémoires discrets, fusibles répartis dans des circuits internes, par exemple, dans des circuits de redondance.

## Revendications

1. Circuit intégré (1) comprenant des éléments de mémoire non volatile électriquement programmable (MEM) et une circuiterie (3) de sélection et programmation associée, le circuit intégré recevant comme tensions d'alimentation externes, une tension de référence de masse (Gnd), au moins une tension d'alimentation logique (Vdd), et une haute tension (HV), ladite haute tension étant utilisée pour fournir les niveaux de tension nécessaires à la programmation d'un ou d'éléments de mémoire non volatile (MEM), **caractérisé en ce qu'**il comprend en outre un dispositif de contrôle (5) de la tension appliquée sur un noeud (N) d'entrée d'alimentation de la circuiterie (3) de sélection et programmation, pour appliquer soit la haute tension (HV), soit une tension d'alimentation logique (Vdd), en fonction d'un signal (IN) de commande de programmation.

2. Circuit intégré selon la revendication 1, comprenant une autre tension d'alimentation logique (Vdda), chaque tension d'alimentation logique étant appliquée à une partie du circuit intégré correspondante, **caractérisé en ce que** la tension d'alimentation logique commutée sur le noeud N est l'une de ces tensions (Vdd, Vdda).

3. Circuit intégré selon la revendication 1 pou 2, **caractérisé en ce que** le dispositif de contrôle (5) comprend un premier transistor de commutation (51) pour appliquer la haute tension (HV) sur le noeud d'entrée d'alimentation de la dite circuiterie de sélection et programmation et un deuxième transistor de commutation (52) pour appliquer la tension d'alimentation logique à commuter (Vdd) sur ledit noeud d'entrée.

4. Circuit intégré selon la revendication 3, **caractérisé en ce que** lesdits transistors de commutation (51, 52) sont complémentaires, et reçoivent sur leur grille un même signal de commande (OUT).

5. Circuit intégré selon l'une des revendications 3 et 4 précédentes, **caractérisé en ce qu'**il comprend un translateur de tension (50) à au moins un étage cascode (M4, M5, M6, M7), ledit translateur étant connecté entre la haute tension (HV) et la tension de référence de masse électrique (Gnd), et commandé par ledit signal binaire de commande (IN), pour fournir en sortie le signal de commande de commutation (OUT) appliqué aux transistors de commutation (51, 52).

6. Circuit intégré selon la revendication 5, le translateur comprenant dans chacune de ses deux branches, un transistor connecté à la haute tension (HV), un transistor connecté à la tension de référence de masse (Gnd) et au moins un transistor cascode entre ces deux transistors, **caractérisé en ce que** le signal de commande de commutation (OUT) fourni en sortie du translateur est pris dans une branche du translateur, entre le transistor connecté à la haute tension et le transistor cascode suivant.
